# EUROPÄISCHE PATENTANMELDUNG

(11) **EP 2 605 405 A1**
(43) Veröffentlichungstag der Anmeldung: **19.06.2013**
(21) Anmeldenummer: 11193189.5
(22) Anmeldetag: 13.12.2011
(51) Int. Cl.: H03K 3/335, H03K 3/84

(54) **Einrichtung und Verfahren zur Erzeugung von Rauschsignalen und Verwendung einer Einrichtung zur Erzeugung von Rauschsignalen**

(71) Anmelder: Tecdata AG, 9240 Uzwil (CH)
(72) Erfinder: Bergmann, Frank, 15537 Grünheide (DE); Bühler, Urs, 9240 Uzwil (CH); Otte, Ralf, 96469 Weinheim (DE)
(74) Vertreter: Hepp Wenger Ryffel AG

(57) **Zusammenfassung**

Die vorliegende Erfindung betrifft einerseits eine Einrichtung zur Erzeugung von Rauschsignalen. Diese weist mindestens eine Avalanche-Diode auf, welche derart angeordnet ist, dass sie bei bestimmungsgemässem Betrieb der Einrichtung in Sperrrichtung gepolt ist. Zudem betritt die Erfindung ein Verfahren zum Erzeugen eines Rauschsignals mit einer solchen Einrichtung und eine Verwendung dieser Einrichtung sowie Verfahren zur Bewertung eines Typs einer Avalanche-Diode oder eines Avalanche-Transistors.

## Beschreibung

Die Erfindung betrifft eine Einrichtung zur Erzeugung von Rauschsignalen, die insbesondere in Systemen zur analogen und digitalen Erzeugung von Rauschen und Zufallssignalen Verwendung finden können. Weiterhin betrifft die Erfindung ein Verfahren und eine Verwendung zum Betreiben einer solchen Einrichtung sowie ein Verfahren zur Bewertung eines Typs einer Avalanche-Diode oder eines Avalanche-Transistors.

Unter Rauschen versteht die Physik allgemein eine Störgrösse mit breitem unspezifischem Frequenzspektrum. Es kann daher als eine Überlagerung mehrerer Schwingungen oder Wellen mit unterschiedlichen Amplituden und Frequenzen beziehungsweise Wellenlängen interpretiert werden.

Rauschen wurde erstmals 1918 von Walter Schottky als physikalisches Phänomen, nämlich als messbare Stromschwankungen, beschrieben. Verstärkt man diese Schwankungen und macht sie hörbar, so erhält man ein Geräusch: das Rauschen. Heutzutage ist die Definition ein wenig allgemeiner: Rauschen ist ein zeitlich veränderliches leistungsbegrenztes Signal, dessen Eigenschaften mathematisch durch einen Zufallsprozess beschrieben werden können. Rauscharten werden häufig nach ihrer Leistungsdichte klassifiziert. Diese entspricht der Änderung der Leistung pro Bandbreite. Vereinfacht bedeutet dies eine Abhängigkeit von der Frequenz.

Man unterscheidet zwei grundsätzliche Rauscharten:
Weisses Rauschen (z.B. Schrotrauschen, thermisches Rauschen) ist in den Ingenieur- und Naturwissenschaften ein Rauschen, das mit konstanter Amplitude alle Frequenzen umfasst. Praktisch kann dieses Signal nicht erzeugt werden, da jede technische Verarbeitung nur einen begrenzten Frequenzumfang hat. Daher ist nur die folgende Rauschart von technischer Bedeutung:

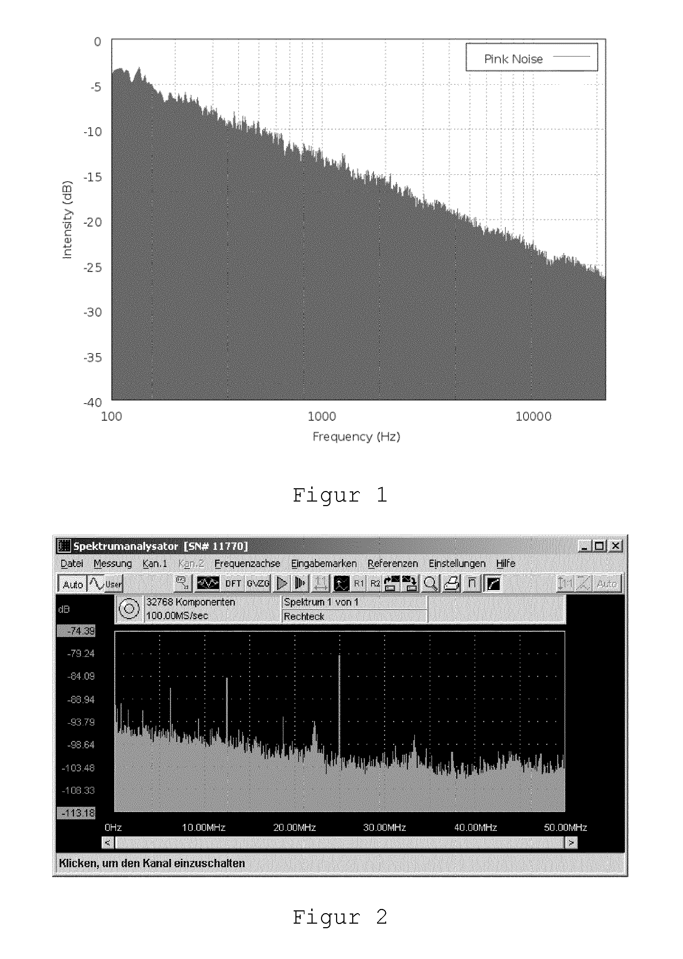

Rosa Rauschen (z.B. 1/f-Rauschen) hat eine spektrale Leistungsdichte, die mit der Frequenz abnimmt. Beim rosa Rauschen haben die niedrigen Frequenzen (tiefe Töne) eine höhere Amplitude als höhere Frequenzen (hohe Töne). Die Amplitude nimmt mit steigenden Frequenzen umgekehrt proportional ab, es sind aber alle Frequenzen vertreten. Beim 1/f-Rauschen handelt es sich um ein Rauschen, das in vielen physikalischen, biologischen aber auch ökonomischen Prozessen auftritt. Ein beispielhaftes Spektrum, welches ein annäherndes 1/f-Rauschen darstellt, ist in Figur 1 wiedergegeben. Dieses Rauschverhalten ist immer dann zu beobachten, wenn bestimmte Ereignisse bei doppelter Geschwindigkeit (respektive bei doppelter Frequenz) nur halb so intensiv auftreten. Dieses ist leicht nachzuvollziehen, weil der Aufwand für Änderungen naturgemäss mit deren Geschwindigkeit immer weiter wächst.

In kommerziellen Applikationen zur Rauschsignalerzeugung werden vor allem folgende Rauschquellen verwendet:
- Widerstände,
- Z-Dioden,
- Transistoren.

Diese Rauschquellen haben typische Amplitudenwerte von 10 µV bis 10 mV. Da oft die Störsignale in elektronischen Systemen in diesen Dimensionen liegen, sind technisch aufwändige Massnahmen notwendig, um einen ausreichend hohen Signal-Störsignalabstand ("signal-to-noise ratio") zu garantieren. Derartige Störsignale können beispielsweise sein: eine Netzfrequenz; Gleichtakte, die von einem Quarzgenerator, Multivibratoren, Prozessor- oder Systemtakten stammen; sowie Artefakte aus der technischen Umgebung der Applikation. Deshalb wird weltweit nach neuen Rauschquellen gesucht, die vor allem
- hohe Rauschsignalamplituden,
- ein breites Frequenzspektrum und
- eine hohe Reproduzierbarkeit
aufweisen.

Analoge Rauschsignale werden vor allem dort benötigt, wo der detaillierte, quantisierte Kurvenverlauf Rückschlüsse auf beinhaltete Informationen zulässt. Hierbei ist es zwingend notwendig, einen möglichst hohen Signal-Störsignalabstand zu erreichen. Denn jede Verstärkung eines Rauschsignals verstärkt ebenso die vor allem auf der Versorgungsspannung modulierten Störspannungen. So hat der Zufallssignalgenerator der Firma Protego (www.protego.se) eine Rauschquelle mit einer primären Signalamplitude von ca. 10 µV und wird etwa 15.000-fach verstärkt.

Viele Bereiche der Informatik sind in steigendem Ausmass auf Zufallszahlen angewiesen. Derartige Zufallszahlen lassen sich in an sich bekannter Weise aus einem Rauschsignal erzeugen, indem dieses Rauschsignal digital abgetastet wird, beispielsweise mit Hilfe eines Schmitt-Triggers. Durch die zunehmende weltweite Vernetzung von Rechnern haben Sicherheitsaspekte in den letzten Jahren an Bedeutung gewonnen. Digitalisierte Rauschsignale werden daher oft für statistische Untersuchungen und zur Erzeugung von kryptografischen Parametern verwendet. In diesen Anwendungen ist vor allem eine hohe Entropie erforderlich. Auch hier bewirken Artefakte, Störsignale und ein geringer Signal-Störsignalabstand eine Reduzierung der Entropie und sind oftmals ein begehrter Ansatz der Kryptoanalysis.

Figur 2 zeigt ein mittels einer Fast-Fourier-Transformation transformiertes Rauschsignal. Hierfür wurde zunächst ein primäres Rauschsignal mit Hilfe eines in Sperrrichtung gepolten Transistors erzeugt, welcher bei einer Sperrspannung von 5 V betrieben wurde. Das Ausgangssignal des Transistors hatte nur eine sehr geringe primäre Rauschsignalamplitude, so dass eine grosse Verstärkung erforderlich war, um Amplituden in der technisch nutzbaren Grössenordnung von mindestens etwa 100 mV zu erhalten. Die Figur 2 zeigt die Fourier-Transformation dieses bereits verstärkten Rauschsignals. Durch die Verstärkung wurden jedoch auch Störsignale verstärkt, die der Qualität des Rauschsignals abträglich sind. So sind signifikante Störsignale etwa bei den Frequenzen 12,5 MHz und 25 MHz erkennbar, welche statistische Auswertungen und Signalanalysen verfälschen.

Zur Bestimmung der Qualität des Rauschens können an sich bekannte mathematisch-statistische Methoden verwendet werden, wie beispielsweise die AIS31-Methode oder der NIST-Test und der Diehard-Test. Mit Hilfe der AIS31-Methode wird die Shannon-Entropie (im Folgenden "Entropie") eines 8-Bit-Rauschsignals bestimmt. Diese Entropie hat für ein solches 8-Bit-Signal einen theoretischen Maximalwert von 8; für ein allgemeines n-Bit-Signal hat sie einen theoretischen Maximalwert von n. Im Allgemeinen und insbesondere in der Kryptographie wird einem Rauschsignal eine gute Qualität beigemessen, wenn der Wert der Entropie eines n-Bit-Rauschsignals grösser als n/ 8×7,97 ist - im Falle eines 8-Bit-Rauschsignals also grösser als 7,97.

Anforderungen an eine ideale weisse Rauschquelle sind unter anderem:
- möglichst grosser Signal-Störsignalabstand (d. h. eine hohe Rauschsignalamplitude und ein kleines Störsignal);
- möglichst wenige oder sogar gar keine Artefakte (wie beispielsweise die in Figur 2 gezeigten);
- möglichst grosse Bandbreite (idealerweise der Frequenzgang von weissem Rauschen);
- möglichst hohe mittlere Frequenz (beispielsweise können umso mehr Zufallszahlen pro gegebener Zeiteinheit erzeugt werden, je höher die Frequenz ist).

Es ist daher eine Aufgabe der Erfindung, eine Einrichtung zur Erzeugung von Rauschsignalen bereitzustellen, welche diesen Anforderungen in möglichst hohem Masse gerecht werden. Insbesondere soll ein primäres Rauschsignal erzeugt werden, welches bereits bei seiner Erzeugung eine derart hohe Rauschsignalamplitude aufweist, dass nur eine relativ geringe oder sogar überhaupt keine Verstärkung des primären Rauschsignals nötig ist. Unter dem "primären Rauschsignal" wird hier und im Folgenden stets das unverstärkte Rauschsignal verstanden. Zudem soll insbesondere das Rauschsignal eine möglichst hohe Qualität haben. Insbesondere soll ein n-Bit-Rauschsignal eine Entropie von mehr als n/ 8×7,97 haben (im Falle eines 8-Bit-Rauschsignals also mehr als 7,97), damit es den Anforderungen der Kryptographie entspricht.

Gemäss einem ersten Aspekt der Erfindung wird dies durch eine Einrichtung gelöst, die mindestens eine Avalanche-Diode aufweist, welche derart angeordnet ist, dass sie bei bestimmungsgemässem Betrieb der Einrichtung in Sperrrichtung gepolt ist.

Der bestimmungsgemässe Betrieb der Einrichtung ergibt sich für den Fachmann aus deren Aufbau. Insbesondere kann der Fachmann dem Aufbau der Einrichtung ansehen, in welcher Polung die Einrichtung mit einer Spannungsquelle verbunden oder zu verbinden ist. Aus dieser Verbindung mit der Spannungsquelle ergibt sich auch die erfindungsgemäss wesentliche Polung der Avalanche-Diode.

Die Spannungsquelle kann selbst Teil der Einrichtung sein. Die Einrichtung kann aber auch Anschlüsse enthalten, welche mit einer separaten Spannungsquelle verbindbar sind.

Bevorzugt ist die Avalanche-Diode durch einen Teil eines Avalanche-Transistors gebildet. Ein Transistor besteht im Prinzip aus zwei in Reihe geschalteten Dioden, wobei eine Diode von der Emitter-Basis-Strecke des Transistors und die andere Diode von der Basis-Kollektor-Strecke des Transistors gebildet wird. Bevorzugt ist die Avalanche-Diode durch die Emitter-Basis-Strecke des Avalanche-Transistors gebildet.

Bei dem Transistor kann es sich um einen pnp-Transistor oder um einen npn-Transistor handeln.

Bei dem Transistor kann es sich beispielsweise um einen Kleinsignaltransistor handeln. Im Rahmen der vorliegenden Erfindung wird ein Transistor als Kleinsignaltransistor bezeichnet, wenn er eine Verlustleistung von weniger als 1 Watt aufweist. Derartige Kleinsignaltransistoren zeichnen sich durch ihre geringe Baugrösse und nicht zuletzt auch durch ihren geringen Preis aus.

Die Erfindung verwendet also Halbleiterbauelemente, bei denen insbesondere der Lawinendurchbruch, auch als Avalanche-Effekt bezeichnet, genutzt wird. Dieser ist charakterisiert durch einen steilen Anstieg des Stroms bei einer bestimmten Sperrspannung eines Halbleiter-p-n-Übergangs, wenn das Halbleiter-Bauelement in Sperrrichtung gepolt ist. Auslöser des Lawinendurchbruchs ist der Lawineneffekt (auch Avalanche-Effekt, Lawinenvervielfachung oder Trägermultiplikation genannt). Im Allgemeinen wirken in der Praxis Zener- und Lawineneffekt gleichzeitig. Dioden und Transistoren lassen sich durch ein kontrolliertes Avalanche-Verhalten vor Zerstörung durch Überspannungen schützen.

Wie sich in Versuchen gezeigt hat, hängt die erfindungsgemäss hohe primäre Rauschsignalamplitude vom Ausmass des Avalanche-Effekts in der Diode, insbesondere in der Emitter-Basis-Strecke des Avalanche-Transistors, ab. Datenblätter zu Halbleiterbauelementen enthalten zumindest in der Regel keine Informationen zum Avalanche-Effekt. Wie überraschend festgestellt wurde, liefern einzelne Typen von Dioden und insbesondere von Transistoren besonders hohe primäre Rauschsignalamplituden. Geeignete Typen von Dioden und Transistoren zur Rauscherzeugung können insbesondere auch empirisch mit einem wie unten beschriebenen Verfahren ermittelt werden. Als geeignet werden Transistoren auch dann angesehen, wenn sich hiermit primäre Rauschspannungen von mindestens 100 mV und/oder mittlere Rauschfrequenzen von mindestens 1 MHz erzeugen lassen. Die Erfinder haben herausgefunden, dass Zener-Effekt und Rauschspektrum bzw. Rauschsignalamplitude miteinander korrelieren. Zudem wurde gefunden, dass sich Transistoren innerhalb eines bestimmten Typs (beispielsweise des Typs BC856C) in ihrer Eignung praktisch nicht unterscheiden. Ist also ein Transistor im obigen Sinne geeignet, so trifft dies im Wesentlichen für alle anderen Transistoren des gleichen Typs zu. Verschiedene Transistoren ein und desselben Typs können verschiedene Zener-Spannungen aufweisen. Alle untersuchten und geeigneten Halbleiterbauelemente mit grosser primärer Rauschsignalamplitude hatten jedoch eine Zener-Spannung im Bereich von 7,0 V bis 12,0 V, insbesondere von 9,5 V bis 11,0 V.

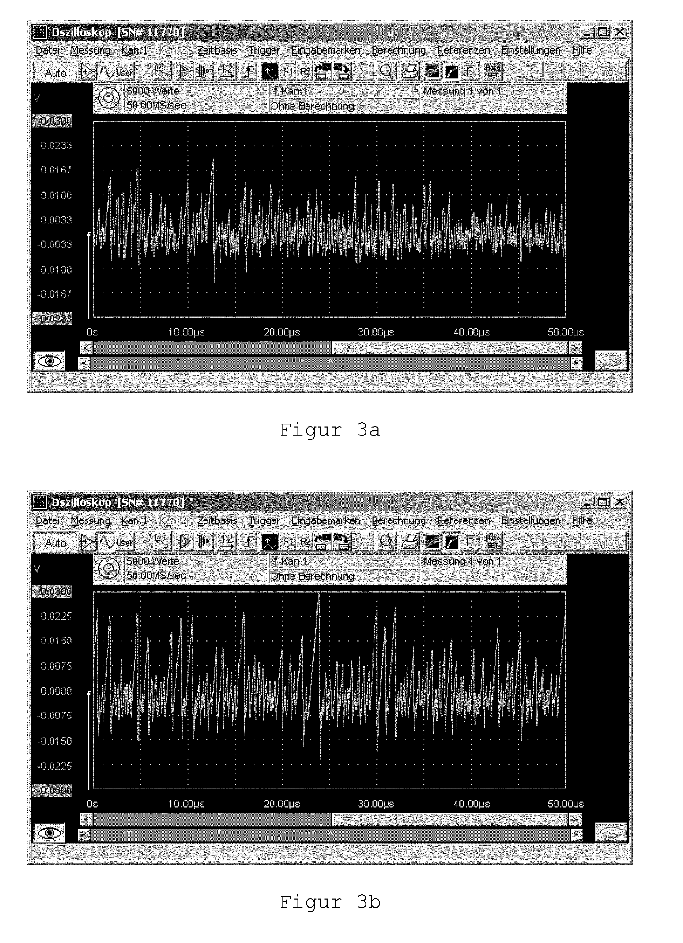

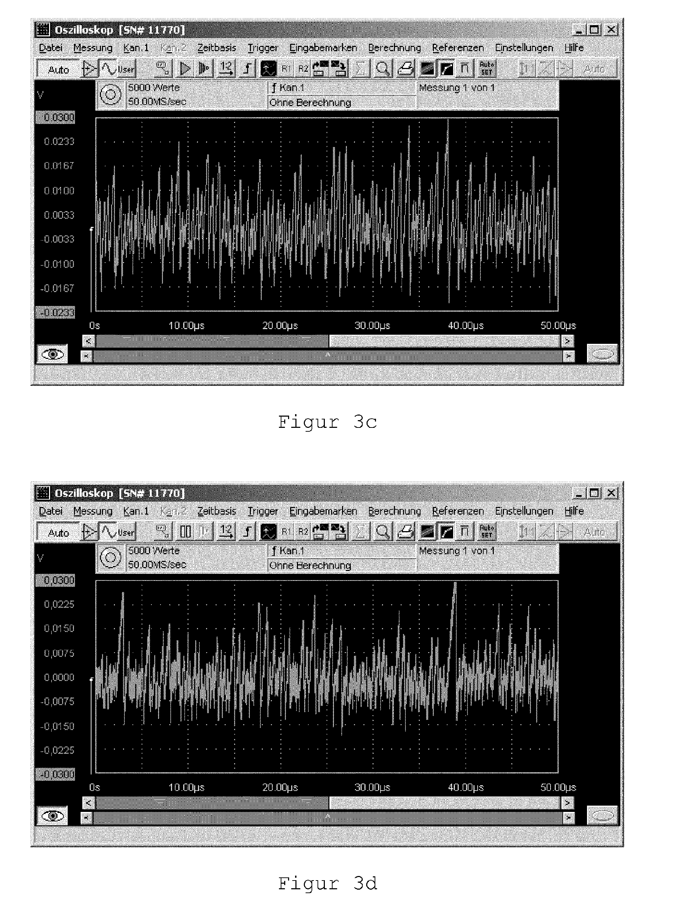

In den Figuren 3a bis 3g sind Rauschsignale dargestellt, die mit Hilfe der folgenden sieben Avalanche-Transistoren erreicht wurden:

| Figur | Typ des Transistors | Polarität des Transistors | Zener-Spannung [V] |
|---|---|---|---|
| 3a | BCW70 | pnp | 10,56 |
| 3b | BCW70 | pnp | 10, 68 |
| 3c | BCW70 | pnp | 10,14 |
| 3d | BCW70 | pnp | 10, 62 |
| 3e | BC817 | npn | 9,26 |
| 3f | BC856C | npn | 9,43 |
| 3g | BC847A | npn | 7, 62 |

Alle Typenbezeichnungen erfolgen jeweils gemäss der European Semiconductor Industry Association (EECA).

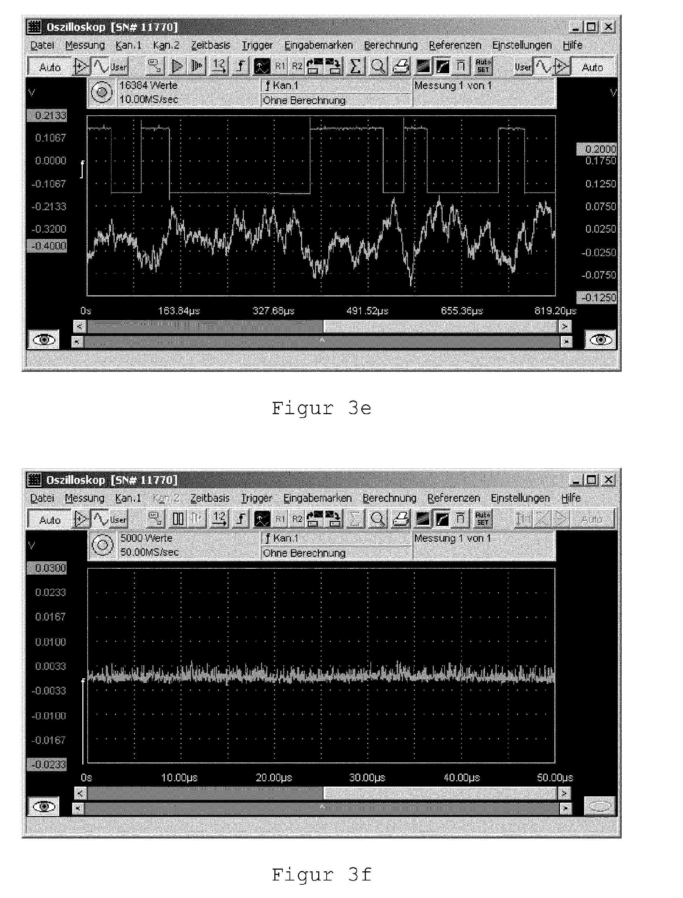

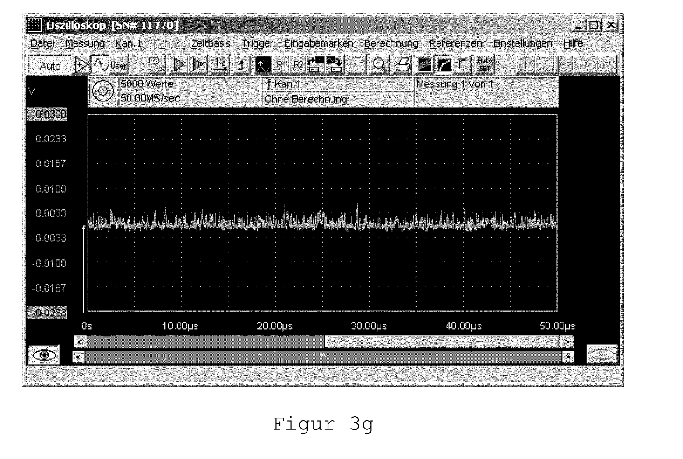

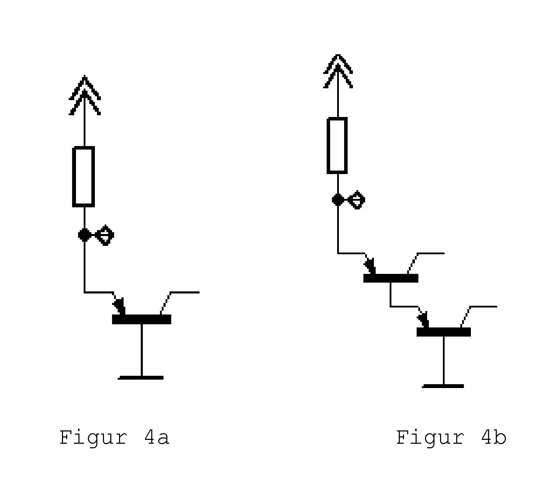

Diese sieben Transistoren wurden in der in Figur 4a dargestellten Schaltung verwendet (siehe unten). Die Rauschsignale gemäss Figuren 3a-3g wurden aus den primären, d. h. unverstärkten Rauschsignalen erhalten, die mit dieser Schaltung erzeugt wurden. Die Rauschsignalamplituden liegen in den in den Figuren 3a-3d gezeigten Beispielen bei einigen 10 mV, bei Figur 3e sogar bei über 100 mV. Bei den Beispielen gemäss den Figuren 3f und 3g sind die Rauschsignalamplituden jedoch deutlich geringer. Aus diesem Grunde sind die ersten fünf Transistoren für die vorliegende Erfindung besonders geeignet.

An den Beispielen gemäss Figuren 3a-3d wird deutlich, dass verschiedene Transistoren ein und desselben Typs (hier BCW70) verschiedene Zener-Spannungen aufweisen können. In Figur 3e zeigt die untere Kurve ein Rauschsignal und die obere Kurve dessen Digitalisierung, die mit einem Schmitt-Trigger erfolgte.

Nach statistischen Erhebungen liefern ca. 25% aller Kleinsignaltransistoren besonders hohe primäre Rauschsignalamplituden, insbesondere wenn sowohl Zener-Effekt als auch Avalanche-Effekt vorhanden sind.

Weitere geeignete Typen von Avalanche-Transistoren und zugehörige Zener-Spannungen sind in der folgenden Tabelle wiedergegeben:

| Typ des Transistors | Polarität des Transistors |
|---|---|
| 2DD2652 (Zener-Spannung z. B. 8,02 V) | npn |
| BC850B | npn |
| BCW70 | pnp |
| BC807 | pnp |
| BC846B | npn |
| MMBTA42 | npn |
| BC860C | pnp |
| BCW30 | pnp |
| BC857A | pnp |

Bevorzugt enthält die Einrichtung mindestens zwei Dioden, weiter bevorzugt mindestens fünf Dioden. Insbesondere kann sie mindestens zwei Transistoren, weiter bevorzugt mindestens fünf Transistoren enthalten. Es wurde eigentlich erwartet, dass sich mehrere Dioden, insbesondere mehrere Transistoren, gegenseitig stören, so dass überhaupt kein kontrollierter Lawinendurchbruch stattfindet. Vollkommen überraschend hat sich jedoch herausgestellt, dass hierdurch die Wirkung der einzelnen Dioden, insbesondere Transistoren, kumuliert werden kann, wodurch die Qualität und insbesondere die Rauschsignalamplitude des Rauschens gesteigert werden kann.

Es hat sich weiterhin gezeigt, dass in der Regel höchstens 14 Transistoren genügen, um ein primäres Rauschsignal mit der erforderlichen Rauschsignalamplitude zu erzeugen.

Besonders vorteilhaft ist es, wenn die Einrichtung mindestens zwei in Reihe geschaltete Dioden aufweist, welche derart angeordnet sind, dass sie bei bestimmungsgemässem Betrieb der Einrichtung in Sperrrichtung gepolt sind. Im Falle einer solchen Reihenschaltung ist es in zumindest in einigen Ausführungsbeispielen denkbar, dass anstelle einer Avalanche-Diode auch andere Dioden verwendet werden, wie beispielsweise Zener-Dioden.

Auch in diesen bevorzugten Ausführungsbeispielen können die Dioden jeweils durch einen Teil eines Transistors gebildet sein, bevorzugt durch die Emitter-Basis-Strecke eines Transistors. In der Reihenschaltung ist bevorzugt die Basis eines ersten pnp-Transistors mit dem Emitter eines zweiten pnp-Transistors verbunden.

Die Figuren 4a und 4b zeigen Schaltbilder zu zwei Einrichtungen zur Erzeugung von Rauschsignalen. Die Schaltung gemäss Figur 4a enthält einen einzigen pnp-Transistor, während die in Figur 4b dargestellte Schaltung zwei pnp-Transistoren enthält. Bei diesen Transistoren handelt es sich jeweils um Avalanche-Transistoren. Dabei ist in Figur 4b die Basis des einen pnp-Transistors mit dem Emitter des zweiten pnp-Transistors verbunden. In beiden Fällen bleiben die Kollektoren der Transistoren unverbunden; es wird also jeweils nur die Basis-Emitter-Strecke verwendet. Die Transistoren können beispielsweise vom Typ BCW70 mit einer Zener-Spannung von 10,91 V sein. Die Widerstände, die einen Wert von 100 kΩ haben können, dienen der Einstellung des Arbeitsstroms, welcher durch den oder die Transistoren fliesst.

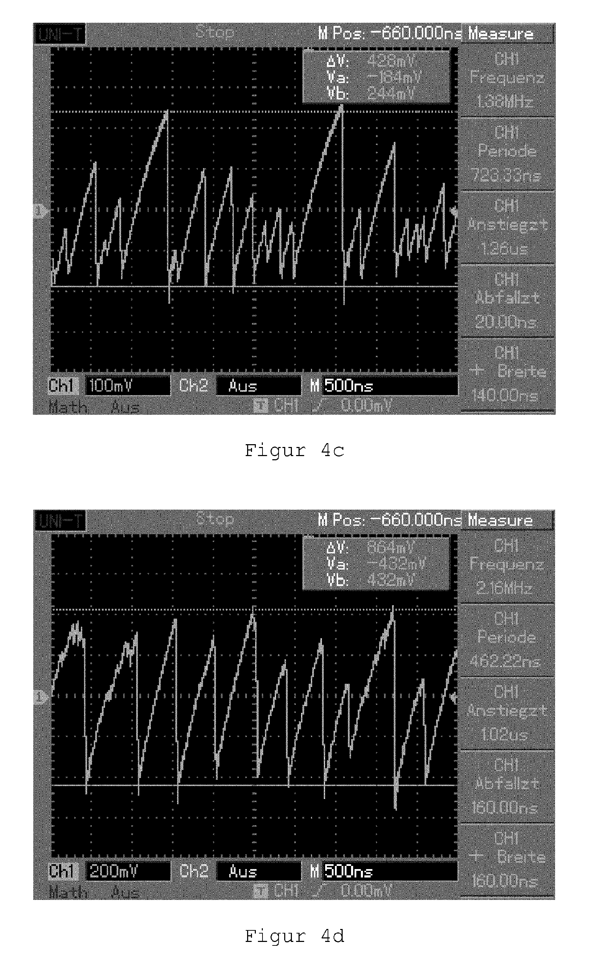

In den Figuren 4c und 4d sind die mit einem Oszilloskop aufgenommenen Signale dargestellt, welche mit den Schaltungen erzeugt wurden. Dabei zeigt Figur 4c das Signal der Schaltung gemäss Figur 4a mit einem Transistor; die primäre, unverstärkte Rauschsignalamplitude beträgt hier 428 mV und die mittlere Frequenz 1,38 MHz. Figur 4d gibt das Signal der Schaltung gemäss Figur 4b mit zwei Transistoren wieder; hier beträgt die primäre, unverstärkte Rauschsignalamplitude sogar 864 mV, ist also mehr als doppelt so gross wie mit einem einzigen Transistor und sogar um beinahe zwei Grössenordnungen grösser als bei den bisher eingesetzten Transistoren. Die mittlere Frequenz liegt im Beispiel gemäss Figur 4d bei 2,16 MHz.

Alternativ oder zusätzlich zur Reihenschaltung können auch mindestens zwei Transistoren parallel zueinander geschaltet sein. Bei der Verwendung von zwei oder drei parallel zueinander geschalteten Transistoren erhöht sich die Rauschfrequenz. Bevorzugt sollten aber nicht mehr als drei Transistoren parallel zueinander geschaltet sein, da ansonsten die Gefahr besteht, dass sich die Rauschquellen durch Überlagerung gegenseitig auslöschen.

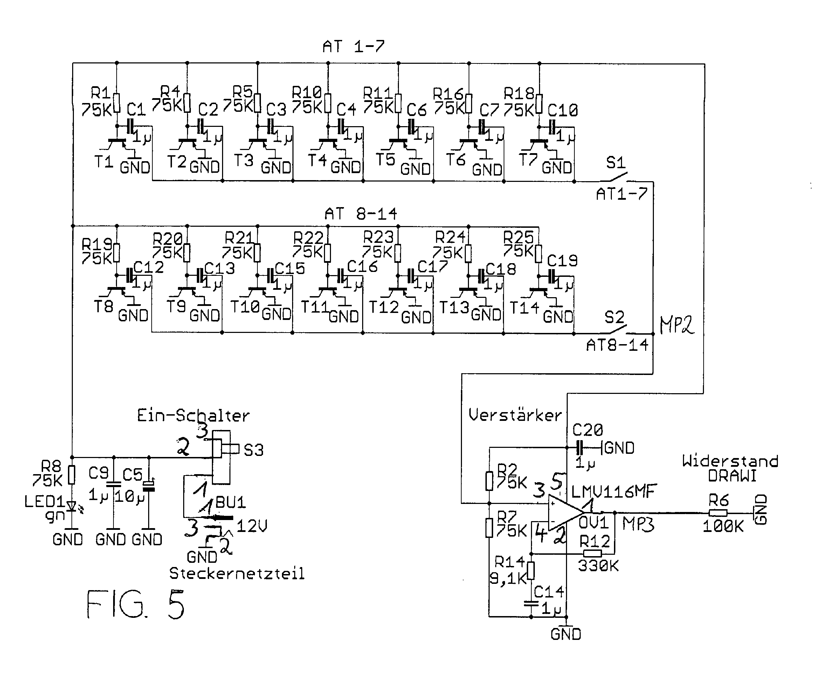

In Figur 5 ist eine Schaltung mit insgesamt 14 parallel geschalteten Avalanche-Transistoren T1 bis T14 vom Typ BCW70 gezeigt. Die Emitter der Transistoren T1 bis T14 sind jeweils mit der Masse verbunden. Die Kollektoren der Transistoren T1 bis T14 bleiben unverbunden; es wird also jeweils nur die Basis-Emitter-Strecke der Transistoren T1-T14 verwendet. Die Transistoren T1 bis T7 sind über einen jeweiligen Kondensator C1-C4, C6, C7 und einen gemeinsamen ersten Schalter S1 mit einem ersten Messpunkt MP2 verbunden. Die Transistoren T8 bis T14 sind über einen jeweiligen Kondensator C10, C12, C13 und C15-C19 und einen gemeinsamen zweiten Schalter S2 mit dem ersten Messpunkt MP2 verbunden. Mit Hilfe der Kondensatoren C1-C4, C6, C7, C10, C12, C13 und C15-C19 (jeweils 1 µF) wird das erzeugte Rauschsignal von Gleichspannungsanteilen entkoppelt. Das unverstärkte Rauschsignal kann am Messpunkt MP2 gegenüber der Masse abgegriffen werden.

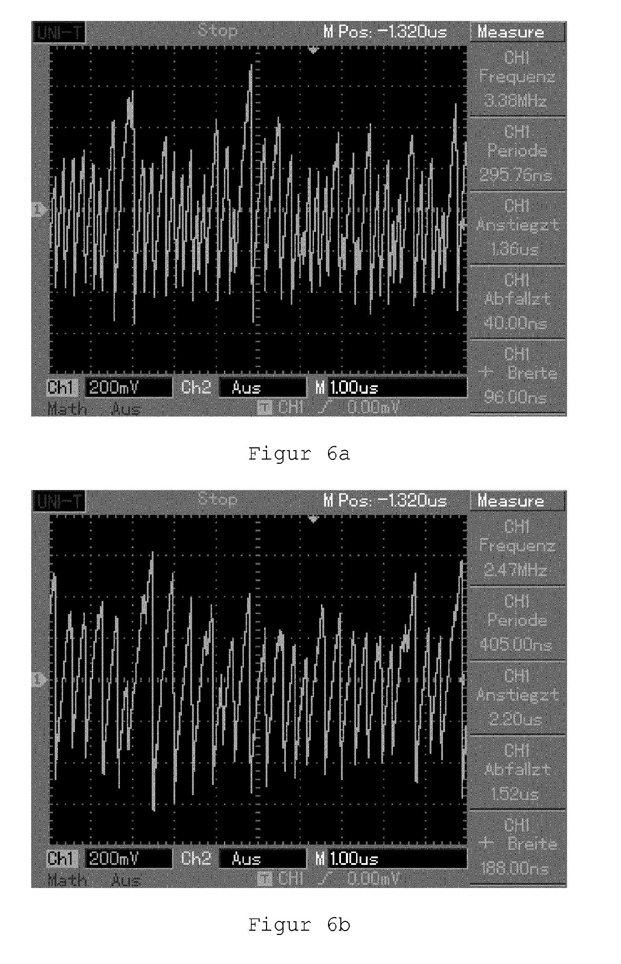

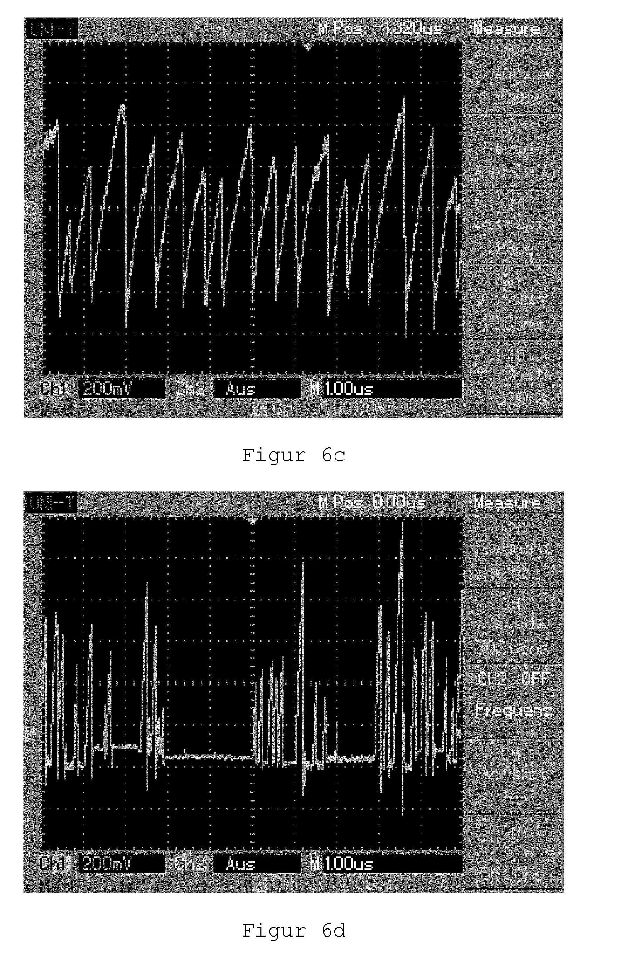

Mittels eines Operationsverstärkers OV1 kann das am ersten Messpunkt MP2 vorliegende Rauschsignal verstärkt werden und dann an einem zweiten Messpunkt MP3 gegenüber der Masse abgegriffen werden. Dieses verstärkte Rauschsignal liegt am Widerstand R6 an. Der Arbeitspunkt der Transistoren T1-T14 kann mittels Strombegrenzung mit einem jeweiligen Widerstand R1, R4, R5, R10, R11, R16 und R18-R25 (jeweils 75 kΩ) auf 20 bis 60 pA eingestellt werden. Unter dem Arbeitspunkt wird hier und im Folgenden der durch die Emitter-Basis-Strecke des Transistors fliessende Strom verstanden. Die Wahl des Arbeitspunktes bestimmt das Rauschspektrum. Dies ist den Figuren 6a bis 6d erkennbar. Dort ist das Rauschsignal bei unterschiedlichen Arbeitspunkten dargestellt. Die jeweiligen Arbeitspunkte sind der folgenden Tabelle zu entnehmen:

| Figur | Arbeitspunkt [pA] |
|---|---|
| 6a | 20 |
| 6b | 35 |
| 6c | 50 |
| 6d | 90 |

Durch Erhöhung des Arbeitspunktes steigt die mittlere Rauschfrequenz. Bei einem Arbeitspunkt von 90 pA oder mehr ist kein kontinuierliches Rauschspektrum mehr möglich: Es entstehen undefinierte Artefakte, wie die Figur 6d deutlich macht.

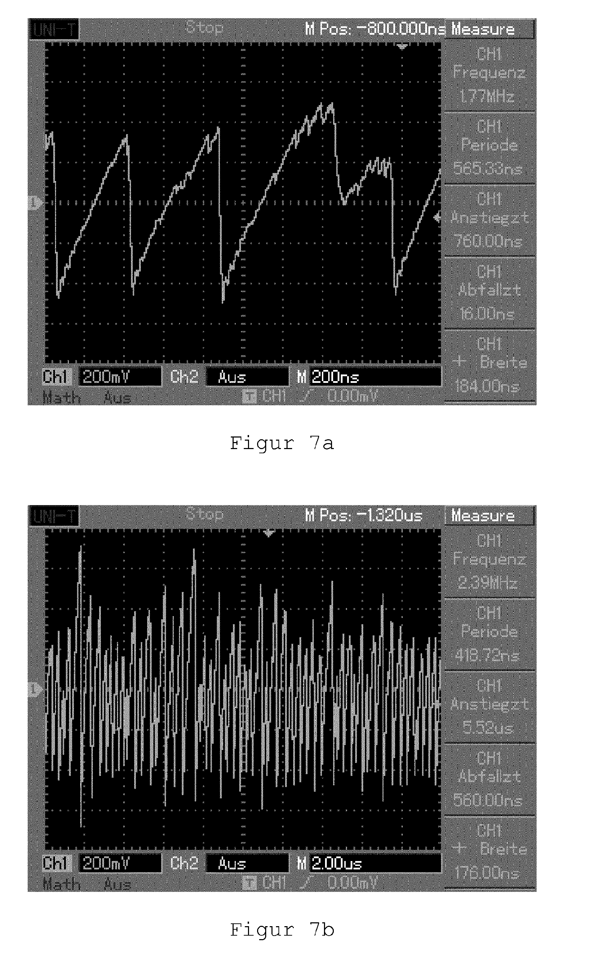

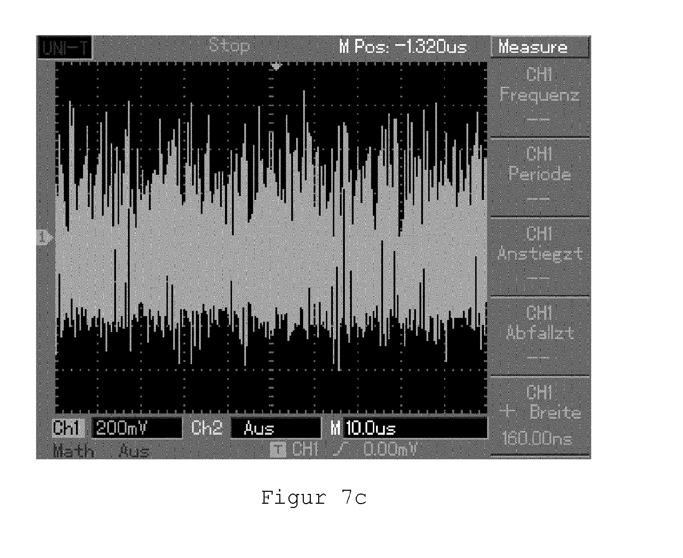

Die Figuren 7a bis 7c zeigen die mit einem Oszilloskop aufgenommenen Rauschsignale, die mit einer Schaltung gemäss Figur 4a und bei einem Arbeitspunkt von 35µA aufgenommen wurden. Die einzelnen Figuren 7a bis 7c zeigen dabei verschiedene zeitliche Auflösungen des Rauschsignals.

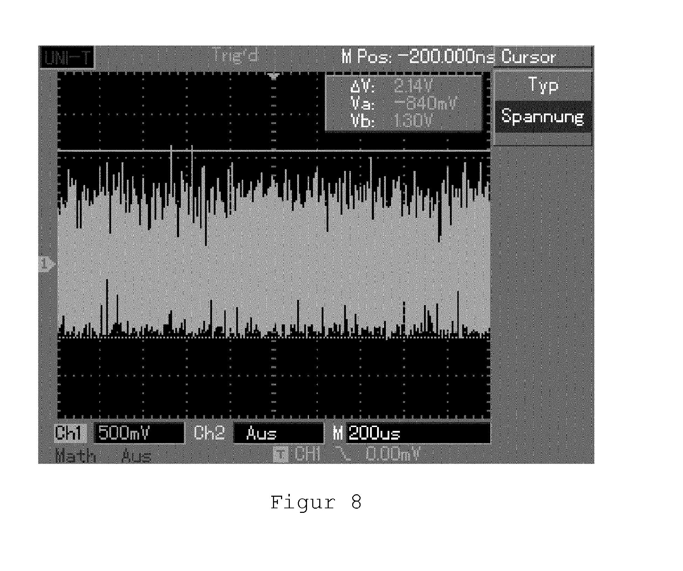

Die Figur 8 zeigt das mit einem Oszilloskop aufgenommene Signal einer Schaltung mit sieben in Reihe geschalteten Transistoren. Die Reihenschaltung erfolgt durch eine sinngemässe Erweiterung der in Figur 4b dargestellten Schaltung, wobei die Basis eines ersten pnp-Transistors mit dem Emitter eines zweiten pnp-Transistors verbunden ist, die Basis des zweiten pnp-Transistors mit dem Emitter eines dritten pnp-Transistors verbunden ist, usw. In dieser Figur 8 ist eine Rauschsignalamplitude von ca. 2,14 V erkennbar, was auf einen ausgeprägten Avalanche-Effekt hindeutet.

Mit der erfindungsgemässen Einrichtung kann ein Rauschsignal erzeugt werden, welches höchsten Ansprüchen an den Signal-Störsignalabstand genügt. Insbesondere können Rauschquellen realisiert werden, die für viele weitere Anwendungen keiner Verstärkung bedürfen, was Vorteile aufgrund geringer Verzerrungen hat. Zudem kann das Rauschsignal ohne Verstärkung bei hochohmiger Ankopplung (beispielsweise bei mehr als 5 MΩ) verarbeitet werden. Zudem zeichnet sich die Einrichtung durch eine geringe Leistungsaufnahme aus. Dies liegt zum einen daran, dass die Diode oder Dioden, insbesondere der/die Transistor(en), in Sperrrichtung gepolt sind, weshalb hierdurch nur ein geringer Strom fliesst. So ist es beispielsweise möglich, dass bei einer angelegten Spannung von 10 V der Gesamtstrom nur bei etwa 35 pA liegt, so dass die Einrichtung mit einer vergleichsweise kleinen Batterie als Spannungsquelle betrieben werden kann. Zudem kann aufgrund der ohnehin hohen primären Rauschsignalamplitude in vielen Fällen auf einen Verstärker verzichtet werden, was zu einer weiteren Reduktion der aufgenommenen Leistung führt.

Das erzeugte Rauschsignal erfüllt auch viele anerkannte Kriterien und Normen hinsichtlich Zufälligkeit, die von einem Rauschsystem erwartet wird, wie beispielsweise die AIS31-Normen, den NIST-Test und den Diehard-Test.

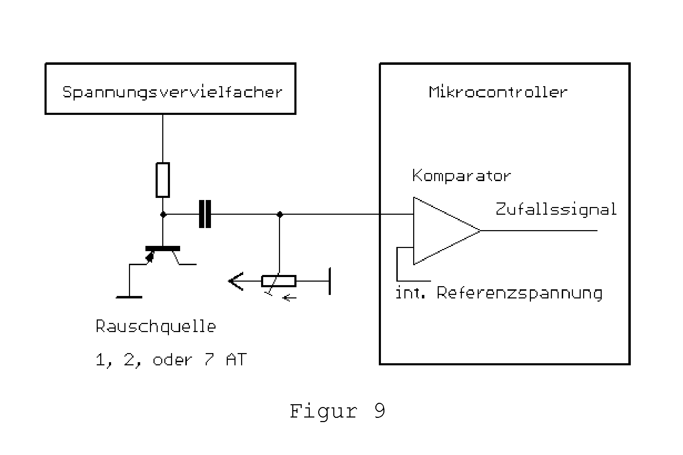

Dies zeigt die direkte Anschaltung verschiedener erfindungsgemässer Einrichtungen zur Erzeugung von Rauschsignalen an einen Standard-Mikrocontroller gemäss Figur 9: Hierbei wird ein Komparator als integrierte Peripherie eines Mikrocontrollers verwendet, um ein analoges Rauschsignal zu digitalisieren. Bisherige Lösungen einer derartigen Applikation sind daran gescheitert, dass keine Rauschquellen mit ausreichender primärer Rauschsignalamplitude zur Verfügung standen. Die (genormte) Untersuchung erfolgte mit einem Avalanche-Transistor (AT), bevorzugt mit einer Reihenschaltung von zwei oder sieben Avalanche-Transistoren. Als Transistor wurde jeweils ein BCW70 verwendet, der über einen Widerstand von 100 kΩ an eine 12-V-Spannungsquelle angeschlossen wurde. Der Kondensator (100 nF) dient der Entkopplung vom Gleichstromanteil. Mit Hilfe eines Potentiometers wurde der Arbeitspunkt des Transistors eingestellt.

Das mit der Vorrichtung gemäss Figur 9 erzeugte Rauschsignal, welches in Figur 4c dargestellt ist, wurde einem AIS31-Test unterzogen.

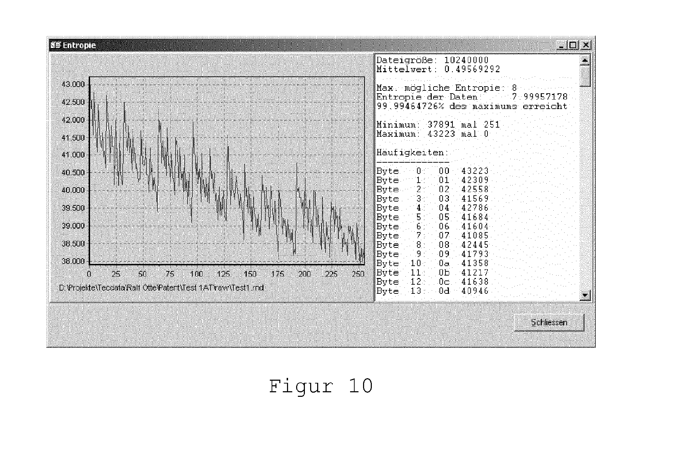

Das digitalisierte 8-Bit-Rauschsignal, welches mit einem einzigen Avalanche-Transistor erzeugt wurde, wies eine Entropie von 7,99957178 auf, welche deutlich über dem Wert von 7,97 liegt (siehe Screenshot in Figur 10). Das Rauschsignal hat in diesem Sinne also eine sehr gute Qualität. Auch die Ergebnisse eines NIST-Tests und eines Diehard-Tests, die mit diesem bearbeiteten Rauschsignal durchgeführt wurden, deuteten auf ein qualitativ hochwertiges Rauschen hin.

Mit zwei in Reihe geschalteten Avalanche-Transistoren ergab sich das in Figur 4d gezeigte Rauschsignal. Die Entropie des digitalisierten primären Rauschsignals lag in diesem Falle bei 7,99946884.

Schliesslich ergab sich für sieben in Reihe geschaltete Transistoren ein Entropiewert von 7,99993702.

Ein weiterer Aspekt der Erfindung betrifft ein Verfahren zum Erzeugen eines Rauschsignals mit Hilfe einer wie oben beschriebenen Einrichtung. Dabei wird diese Einrichtung so betrieben, dass die Diode(n) in Sperrrichtung gepolt ist/sind. In den Fällen, in denen die Diode durch einen Teil eines Transistors gebildet ist, wird die Einrichtung bevorzugt so betrieben, dass der Transistor in Sperrrichtung der Emitter-Basis-Strecke des Transistors gepolt ist. Auf diese Weise kann ein Rauschen mit den oben beschriebenen vorteilhaften Eigenschaften erzeugt werden. Bevorzugt liegt bei diesem Verfahren der Arbeitspunkt der Diode, insbesondere des Transistors, im Bereich von 20 pA bis 100 pA, bevorzugt von 20 pA bis 60 pA.

Weiterhin bevorzugt kann dieser Arbeitspunkt durch einen ohmschen Widerstand eingestellt werden. Diese Möglichkeit der Einstellung des Arbeitspunktes ist baulich besonders einfach und zudem kostengünstig.

Noch ein weiterer Aspekt der Erfindung betrifft die Verwendung einer wie oben beschriebenen Einrichtung zur Erzeugung eines Rauschsignals und/oder eines Zufallssignals. Derartige Zufallszahlen lassen sich in an sich bekannter Weise aus dem Rauschsignal erzeugen, welches durch die erfindungsgemässe Einrichtung generiert wird, beispielsweise mit Hilfe eines Schmitt-Triggers.

Zudem betrifft die Erfindung ein Verfahren zur Bewertung eines Typs einer Avalanche-Diode oder eines Avalanche-Transistors, enthaltend die folgenden Schritte:
a) Hindurchleiten eines Stroms durch die Avalanche-Diode bzw. durch die Emitter-Basis-Strecke des Avalanche-Transistors in Sperrrichtung;
b) Ableitung des Spannungssignals, welches zwischen den Polen der Avalanche-Diode bzw. zwischen dem Emitter und der Basis des Avalanche-Transistors anliegt;
c) Digitalisierung des Spannungssignals zur Erzeugung eines digitalisierten n-Bit-Rauschsignals;
d) Durchführung eines AIS31-Tests mit dem digitalisierten Rauschsignal und Bestimmung der Shannon-Entropie des digitalisierten Rauschsignals;
e) falls die Shannon-Entropie mindestens n/8×7,97 beträgt: positive Bewertung der Avalanche-Diode bzw. des Avalanche-Transistors; oder, falls die die Shannon-Entropie weniger als n/8×7,97 beträgt: negative Bewertung der Avalanche-Diode bzw. des Avalanche-Transistors.

Mit diesem Verfahren ist es also möglich, aus einer Menge von Typen von Avalanche-Dioden bzw. Avalanche-Transistoren einzelne Typen von Avalanche-Dioden bzw. Avalanche-Transistoren auszuwählen, welche zur Erzeugung von Zufallszahlen besonders geeignet sind. Die Typen von Dioden bzw. Transistoren werden nämlich dann als positiv und damit als geeignet bewertet, wenn die damit erreichte Shannon-Entropie mindestens den Schwellenwert von n/8×7,97 hat. Entgegen der Erwartung wurde von den Erfindern vollkommen überraschend gefunden, dass derart hohe Shannon-Entropien überhaupt mit Avalanche-Dioden oder Avalanche-Transistoren erzielt werden konnten.

## Patentansprüche

1. Einrichtung zur Erzeugung von Rauschsignalen,
**dadurch gekennzeichnet, dass**
sie mindestens eine Avalanche-Diode aufweist, welche derart angeordnet ist, dass sie bei bestimmungsgemässem Betrieb der Einrichtung in Sperrrichtung gepolt ist.

2. Einrichtung zur Erzeugung von Rauschsignalen, insbesondere nach Anspruch 1,
**dadurch gekennzeichnet, dass**
sie mindestens zwei, bevorzugt mindestens fünf in Reihe geschaltete Dioden aufweist, welche derart angeordnet sind, dass sie bei bestimmungsgemässem Betrieb der Einrichtung in Sperrrichtung gepolt sind.

3. Einrichtung gemäss einem der vorangehenden Ansprüche,
**dadurch gekennzeichnet, dass**
die Diode, insbesondere die Avalanche-Diode, durch einen Teil eines Transistors (T1, ..., T14), insbesondere eines Avalanche-Transistors, gebildet ist.

4. Einrichtung gemäss Anspruch 3,
**dadurch gekennzeichnet, dass**
die Diode, insbesondere die Avalanche-Diode, durch die Emitter-Basis-Strecke eines Transistors (T1, ..., T14), insbesondere eines Avalanche-Transistors gebildet ist.

5. Einrichtung gemäss Anspruch 4,
**dadurch gekennzeichnet, dass**
die Zener-Spannung der Emitter-Basis-Strecke im Bereich 7,0 V bis 12,0 V, insbesondere von 9,5 V bis 11,0 V liegt.

6. Einrichtung nach Anspruch 3 bis 5,
**dadurch gekennzeichnet, dass**
sie mindestens zwei Transistoren enthält, wobei die Basis eines ersten Transistors mit dem Emitter eines zweiten Transistors verbunden ist.

7. Einrichtung nach einem der vorangehenden Ansprüche,
**dadurch gekennzeichnet, dass**
sie mindestens zwei Dioden, insbesondere mindestens zwei Transistoren (T1, ..., T14) enthält, welche parallel zueinander geschaltet sind.

8. Verfahren zum Erzeugen eines Rauschsignals mit Hilfe einer Einrichtung gemäss einem der vorangehenden Ansprüche, wobei die Einrichtung derart betrieben wird, dass die Diode(n) in Sperrrichtung gepolt ist/sind.

9. Verfahren nach Anspruch 8,
**dadurch gekennzeichnet, dass**
die Diode durch die Emitter-Basis-Strecke eines Transistors (T1, ..., T14) gebildet ist und die Einrichtung derart betrieben wird, dass der Transistor (T1, ..., T14) in Sperrrichtung der Emitter-Basis-Strecke gepolt ist.

10. Verfahren nach Anspruch 8 oder 9,
**dadurch gekennzeichnet, dass**
der Arbeitspunkt der Diode, insbesondere des Transistors (T1, ..., T14), im Bereich von 20 pA bis 100 pA liegt, bevorzugt von 20 pA bis 60 pA.

11. Verfahren nach Anspruch 10,
**dadurch gekennzeichnet, dass**
der Arbeitspunkt des Transistors (T1, ..., T14) durch einen ohmschen Widerstand eingestellt wird.

12. Verwendung einer Einrichtung gemäss einem der Ansprüche 1 bis 7 zur Erzeugung eines Rauschsignals und/oder eines Zufallssignals.

13. Verfahren zur Bewertung eines Typs einer Avalanche-Diode oder eines Avalanche-Transistors, enthaltend die folgenden Schritte:
a) Hindurchleiten eines Stroms durch die Avalanche-Diode bzw. durch die Emitter-Basis-Strecke des Avalanche-Transistors in Sperrrichtung;
b) Ableitung des Spannungssignals, welches zwischen den Polen der Avalanche-Diode bzw. zwischen dem Emitter und der Basis des Avalanche-Transistors anliegt;
c) Digitalisierung des Spannungssignals zur Erzeugung eines digitalisierten n-Bit-Rauschsignals;
d) Durchführung eines AIS31-Tests mit dem digitalisierten Rauschsignal und Bestimmung der Shannon-Entropie des digitalisierten Rauschsignals;
e) falls die Shannon-Entropie mindestens n/8×7,97 beträgt: positive Bewertung der Avalanche-Diode bzw. des Avalanche-Transistors; oder, falls die die Shannon-Entropie weniger als n/8×7,97 beträgt: negative Bewertung der Avalanche-Diode bzw. des Avalanche-Transistors.
